# FASCICULE DE BREVET EUROPEEN

(11) **EP 2 885 674 B1**
(45) Date de publication et mention de la délivrance du brevet: **01.02.2017**
(21) Numéro de dépôt: 13753423.6
(22) Date de dépôt: 13.08.2013
(51) Int. Cl.: G02F 1/157, G02F 1/155

(54) **DISPOSITIF D'AFFICHAGE ÉLECTROLUMINESCENT ET ÉLECTROCHROME, PROCÉDÉ DE FABRICATION ASSOCIÉ**
ELEKTROLUMINESZENTE UND ELEKTROCHROME ANZEIGEVORRICHTUNG UND ZUGEHÖRIGES HERSTELLUNGSVERFAHREN
ELECTROLUMINESCENT AND ELECTROCHROMIC DISPLAY DEVICE, AND ASSOCIATED METHOD OF MANUFACTURE

(30) Priorité: 14.08.2012 FR 1257812
(43) Date de publication de la demande: 24.06.2015
(73) Titulaire: Commissariat à l'Énergie Atomique et aux Énergies Alternatives, 75015 Paris (FR)
(72) Inventeur: OUKASSI, Sami, F-38120 Saint-Egreve (FR)
(74) Mandataire: Novaimo
(86) Numéro de dépôt international: PCT/EP2013/066865
(87) Numéro de publication internationale: WO 2014/026962

(56) Documents cités:
- GB-A- 2 297 071
- US-A1- 2004 189 187
- US-A1- 2008 203 910

## Description

### Domaine technique de l'invention

L'invention concerne le domaine de l'affichage de données, notamment à base d'afficheur microélectronique.

L'invention a pour objet plus particulièrement un dispositif d'affichage comprenant un premier élément d'affichage comportant un premier empilement de couches et un deuxième élément d'affichage comportant un deuxième empilement de couches.

### État de la technique

Dans le domaine de l'affichage d'information, il est possible d'utiliser deux technologies.

Une première technologie est relative à un affichage électroluminescent basé sur le principe d'émission de lumière à partir d'un matériau suite à son excitation par une contrainte électrique extérieure. Cette émission est intrinsèque aux matériaux utilisés, et est caractérisée par une ou plusieurs longueurs d'ondes ainsi qu'une certaine intensité. Un tel affichage présente un fonctionnement en mode émissif. Le mode émissif présente un inconvénient résultant d'une dégradation des propriétés d'affichage dans un environnement de forte luminosité. En effet, dans le cas où la luminosité ambiante est supérieure à la luminosité émise par l'affichage électroluminescent, les pixels émissifs sont difficilement visibles, et la lecture des données affichées est considérablement dégradée.

Une deuxième technologie est relative à un affichage électrochrome basé sur le principe de changement d'état optique d'un matériau actif, pouvant être lié à au moins une variation de transmittance, absorbance ou réflectance suite à l'application d'une contrainte électrique audit matériau actif. Un tel affichage présente un fonctionnement en mode réflectif et de ce fait, est caractérisé par une dégradation des propriétés d'affichage dans un environnement de faible luminosité. En effet, si la luminosité ambiante est faible, la réflexion induite est très réduite et le contraste entre l'état coloré et l'état transparent de l'affichage n'est pas suffisant pour assurer un bon affichage de données.

Afin de s'affranchir des problématiques de ces deux technologies, il a été proposé des co-intégrations d'éléments électrochromes et d'éléments électroluminescents au niveau d'un même composant.

Le document US20110062860 propose pour cela un unique empilement assurant de manière exclusive un affichage par un élément électroluminescent de l'empilement ou un affichage par un élément électrochrome de l'empilement. L'empilement présente une électrode commune aux éléments électroluminescent et électrochrome. Cependant, avec un tel afficheur comportant un pixel équipé des deux fonctions au sein d'un même empilement, l'affichage peut, dans certaines conditions de luminosité, être correct mais rester décevant.

Le document GB-A-2 297 071 divulgue un dispositif comprenant deux empilements disposés côte à côte sur un substrat, ces deux empilements étant tous deux à fonction exclusivement électrochrome. Les documents US-A-2008/203910 ainsi que US-A-2004/189187 divulguent un dispositif comprenant un premier empilement à fonction exclusivement électroluminescente et un second empilement à fonction exclusivement électrochrome, ces deux empilements étant toutefois superposés et non disposés côte à côte.

### Objet de l'invention

Le but de la présente invention est de proposer une solution permettant notamment d'améliorer le rendu de l'affichage.

On tend vers ce but en ce que les premier et deuxième éléments d'affichage du dispositif d'affichage sont disposés côte à côte de sorte à délimiter une première zone d'affichage exclusivement électroluminescente associée au premier élément d'affichage et une deuxième zone d'affichage exclusivement électrochrome associée au deuxième élément d'affichage.

Avantageusement, le premier empilement comporte au moins une couche de même matériau qu'une couche du deuxième empilement.

Par exemple, le premier empilement comporte une couche formant au moins un collecteur de courant dudit premier empilement, de même matériau qu'une couche du deuxième empilement formant un collecteur de courant du deuxième empilement.

Par exemple, le premier empilement comporte une couche électroluminescente de même matériau qu'une couche formant un collecteur de courant du deuxième empilement.

Par exemple, le deuxième empilement comporte une couche formant un électrolyte de même matériau qu'une couche du premier empilement formant une isolation électrique entre un collecteur de courant du premier empilement et une couche électroluminescente du premier empilement.

Avantageusement, le premier élément d'affichage comporte une pluralité de premiers empilements disposés côte à côte et formant la zone d'affichage électroluminescente associée.

Selon une mise en oeuvre, le premier empilement s'étend le long d'un substrat de support et le deuxième empilement s'élève du substrat de support dans une direction opposée audit substrat de support.

Avantageusement, le dispositif comprend un module de pilotage de l'affichage configuré de sorte à faire fonctionner sélectivement l'affichage dans les modes suivants :
- Un mode d'affichage exclusivement luminescent,
- Un mode d'affichage exclusivement électrochrome,
- Un mode d'affichage luminescent et électrochrome.

Préférentiellement, chaque couche du premier empilement est aussi présente dans le deuxième empilement.

L'invention est aussi relative à un procédé de fabrication d'un dispositif d'affichage tel que décrit, ledit procédé comprenant une étape de formation du premier élément d'affichage et du deuxième élément d'affichage.

De préférence, l'étape de formation comprend une première étape de dépôt d'un premier matériau réalisée de sorte à former simultanément une couche du premier empilement et une couche du deuxième empilement avec le premier matériau.

Le premier matériau peut être choisi parmi :
- un matériau formant, après son dépôt, une couche destinée à former au moins un collecteur de courant, de préférence deux collecteurs de courant, du premier empilement et une couche destinée à former un des collecteurs de courant du deuxième empilement, ou
- un matériau formant, après son dépôt, une couche électroluminescente du premier empilement et une couche destinée à former un des collecteurs de courant du deuxième empilement, ou
- un matériau formant, après son dépôt, une couche destinée à former un électrolyte du deuxième empilement, et une couche destinée à former une isolation électrique entre au moins un collecteur de courant, de préférence deux collecteurs de courant, du premier empilement et une couche électroluminescente du premier empilement.

De préférence, l'étape de formation comprend une deuxième étape de dépôt d'un deuxième matériau configurée de sorte à former simultanément une couche du premier empilement et une couche du deuxième empilement avec ledit deuxième matériau.

Le deuxième matériau peut être choisi parmi:
- un matériau formant, après son dépôt, une couche destinée à former au moins un collecteur de courant, de préférence deux collecteurs de courant, du premier empilement et une couche destinée à former un des collecteurs de courant du deuxième empilement, ou
- un matériau formant, après son dépôt, une couche électroluminescente du premier empilement et une couche destinée à former un des collecteurs de courant du deuxième empilement, ou
- un matériau formant, après son dépôt, une couche destinée à former un électrolyte du deuxième empilement, et une couche destinée à former une isolation électrique entre au moins un collecteur de courant, de préférence deux collecteurs de courant, du premier empilement et une couche électroluminescente du premier empilement,
ledit deuxième matériau étant distinct du premier matériau.

De préférence, l'étape de formation comprend une troisième étape de dépôt d'un troisième matériau configurée de sorte à former simultanément une couche du premier empilement et une couche du deuxième empilement avec ledit troisième matériau.

Le troisième matériau peut être choisi parmi:
- un matériau formant, après son dépôt, une couche destinée à former au moins un collecteur de courant, de préférence deux collecteurs de courant, du premier empilement et une couche destinée à former un des collecteurs de courant du deuxième empilement, ou
- un matériau formant, après son dépôt, une couche électroluminescente du premier empilement et une couche destinée à former un des collecteurs de courant du deuxième empilement, ou
- un matériau formant, après son dépôt, une couche destinée à former un électrolyte du deuxième empilement, et une couche destinée à former une isolation électrique entre au moins un collecteur de courant, de préférence deux collecteurs de courant, du premier empilement et une couche électroluminescente du premier empilement,
ledit troisième matériau étant distinct du premier matériau et du deuxième matériau.

Bien que non revendiqué, le matériau, formant après son dépôt une couche destinée à former au moins un collecteur de courant du premier empilement et une couche destinée à former un des collecteurs de courant du deuxième empilement, est de l'ITO ou du F :SnO₂.

Bien que non revendiqué, le matériau, formant après son dépôt une couche électroluminescente du premier empilement et une couche destinée à former un des collecteurs de courant du deuxième empilement, est du ZnO.

Bien que non revendiqué, le matériau, formant après son dépôt une couche destinée à former un électrolyte du deuxième empilement et une couche destinée à former une isolation électrique entre au moins un collecteur de courant du premier empilement et une couche électroluminescente du premier empilement, est du LiF ou du LiPON.

Selon une mise en oeuvre non revendiquée, l'étape de formation des premier et deuxième éléments d'affichage est réalisée de telle manière que chaque couche du premier empilement est associée à une couche du deuxième empilement obtenue par dépôt simultané.

Bien que non revendiqué, l'étape de formation des premier et deuxième éléments d'affichage étant réalisée à partir d'un substrat de support, le premier empilement s'étend le long du substrat de support et le deuxième empilement s'élève du substrat de support dans une direction opposée audit substrat de support.

### Description sommaire des dessins

D'autres avantages et caractéristiques ressortiront plus clairement de la description qui va suivre de modes particuliers de réalisation de l'invention donnés à titre d'exemples non limitatifs et représentés sur les dessins annexés, dans lesquels :
- la figure 1 est une vue en coupe d'un dispositif d'affichage selon un mode de réalisation de l'invention,
- la figure 2 est une vue en coupe d'un dispositif d'affichage selon un autre mode de réalisation de l'invention,
- la figure 3 illustre une représentation plus schématique du mode de réalisation de la figure 2,
- la figure 4 illustre une réalisation particulière d'un dispositif d'affichage sous forme d'une matrice présentant des pixels électroluminescents et électrochromes.

### Description de modes préférentiels de l'invention

Le présent dispositif d'affichage diffère de l'art antérieur notamment en ce que le dispositif comporte deux éléments d'affichage de types différents (électrochrome et électroluminescent) disposés côte à côte, sans qu'un élément d'affichage ne soit empilé avec un élément d'affichage d'un type différent.

Dans la présente description, un élément d'affichage peut aussi être assimilé à un pixel.

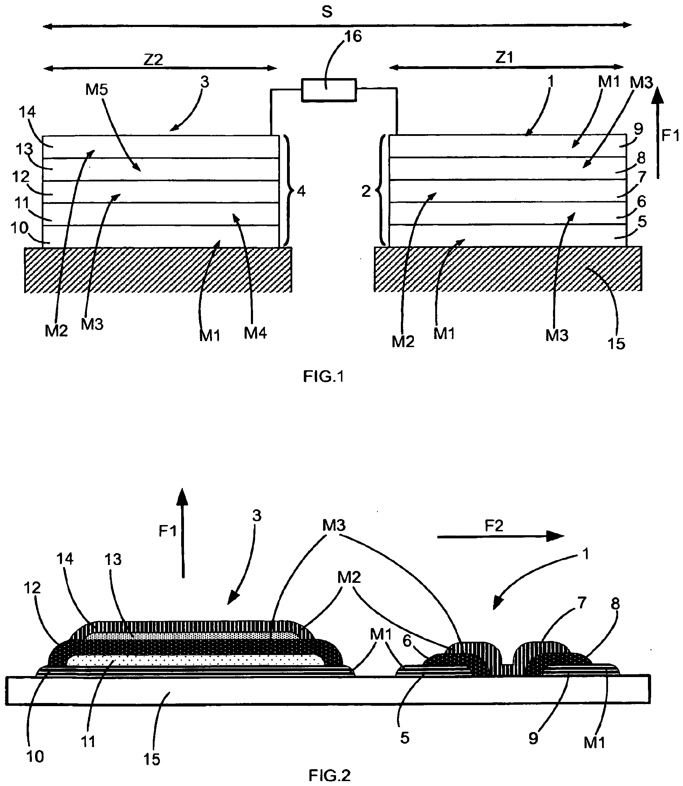

Comme illustré à la figure 1, le dispositif d'affichage comprend un premier élément d'affichage 1 comportant un premier empilement 2 de couches et un deuxième élément d'affichage 3 comportant un deuxième empilement 4 de couches. Les premier et deuxième éléments d'affichage 1, 3 sont disposés côte à côte de sorte à délimiter une première zone d'affichage exclusivement électroluminescente Z1 associée au premier élément d'affichage 1 et une deuxième zone d'affichage exclusivement électrochrome Z2 associée au deuxième élément d'affichage 3.

Les première et deuxième zones d'affichage peuvent faire partie d'une surface d'affichage S.

Autrement dit, le premier élément d'affichage 1 est un élément d'affichage électroluminescent et le deuxième élément d'affichage 3 est un élément d'affichage électrochrome.

Par rapport à l'art antérieur, une telle configuration permet de conserver les propriétés optiques des deux éléments d'affichage en évitant de les dégrader en les empilant. En effet, chaque couche empilée est caractérisée par une transmittance intrinsèque au matériau qui la constitue et qui est non nulle. L'empilement de plusieurs éléments d'affichage selon le document de l'art antérieur induit une baisse de la transmittance globale du système et implique de ce fait une baisse du contraste entre un état transparent et un état coloré

Un élément d'affichage électroluminescent 1 peut comporter, comme illustré à la figure 1, un empilement successif de couches suivantes : une couche formant un premier collecteur de courant 5, une couche formant un premier isolant électrique 6, une couche électroluminescente 7 d'un matériau idoine qui s'illumine lors de l'application d'une charge électrique, une couche formant un deuxième isolant électrique 8, une couche formant un deuxième collecteur de courant 9.

Un élément d'affichage électrochrome 3 peut comporter, comme illustré à la figure 1, un empilement successif de couches suivantes : une couche formant un premier collecteur de courant 10, une couche formant une première électrode 11, une couche d'électrolyte 12 formant un isolant électronique et un conducteur ionique, une couche formant une deuxième électrode 13 et une couche formant un deuxième collecteur de courant 14. Au moins une des deux électrodes 11, 13 est capable de changer de couleur, ou d'état, lors de l'application d'une charge électrique.

L'élément d'affichage électrochrome 3 et l'élément d'affichage électroluminescent 1 peuvent être réalisés sur un même substrat de support 15 à partir de dépôts idoines des différentes couches énumérées ci-dessus.

On comprend de ce qui a été dit ci-dessus que les empilements peuvent être réalisés par dépôt de couches selon des technologies notamment de microélectronique à partir d'un même substrat de support 15.

Bien entendu, l'élément d'affichage électroluminescent 1 et l'élément d'affichage électrochrome 3 tels que décrits ci-dessus ne sont donnés qu'à titre d'exemple particulier de réalisation.

Outre le fait que la disposition côte à côte de l'élément d'affichage électrochrome 3 et de l'élément d'affichage électroluminescent 1 permette d'améliorer l'affichage par rapport à l'art antérieur pour les raisons évoquées ci-dessus, une telle disposition permet de piloter l'affichage des deux éléments d'affichage 1, 3 de manière indépendante. Autrement dit, le dispositif d'affichage peut comprendre de manière avantageuse un module de pilotage 16 de l'affichage configuré de sorte à faire fonctionner sélectivement l'affichage dans les modes suivants : un mode d'affichage exclusivement luminescent, un mode d'affichage exclusivement électrochrome, un mode d'affichage luminescent et électrochrome.

Ainsi, sur une même surface d'affichage il est possible de faire fonctionner de manière concomitante au moins une zone d'affichage électroluminescente et au moins une zone d'affichage électrochrome.

L'avantage du mode d'affichage luminescent et électrochrome est de permettre la meilleure visibilité possible quelles que soient les conditions de luminosité. Ceci permet de s'abstenir de la présence d'un capteur de luminosité permettant le passage d'un mode à l'autre, ou d'une problématique de trou dans l'affichage lors du passage d'un mode à l'autre.

De préférence, afin de faciliter la fabrication du dispositif, et donc de limiter les coûts en matériaux et en étapes de fabrication, certains matériaux utilisés dans l'architecture du premier empilement peuvent être aussi utilisés dans l'architecture du deuxième empilement.

Autrement dit, selon un mode de réalisation préféré du dispositif d'affichage, le premier empilement 2 peut comporter au moins une couche de même matériau qu'une couche du deuxième empilement 4.

Selon une première mise en oeuvre du mode de réalisation préféré, le premier empilement 2 peut comporter une couche formant au moins un collecteur de courant 5, 9 dudit premier empilement 2 réalisée d'un même matériau M1 qu'une couche du deuxième empilement 4 formant un collecteur de courant 10 du deuxième empilement 4. De préférence, les deux collecteurs de courant 5, 9 du premier empilement 2 sont réalisés en matériau M1.

Sur l'exemple de la figure 1, le premier collecteur de courant 5 du premier empilement 2 de l'élément d'affichage électroluminescent 1 et le premier collecteur de courant 10 du deuxième empilement 4 de l'élément d'affichage électrochrome 3 sont réalisés avec le matériau M1.

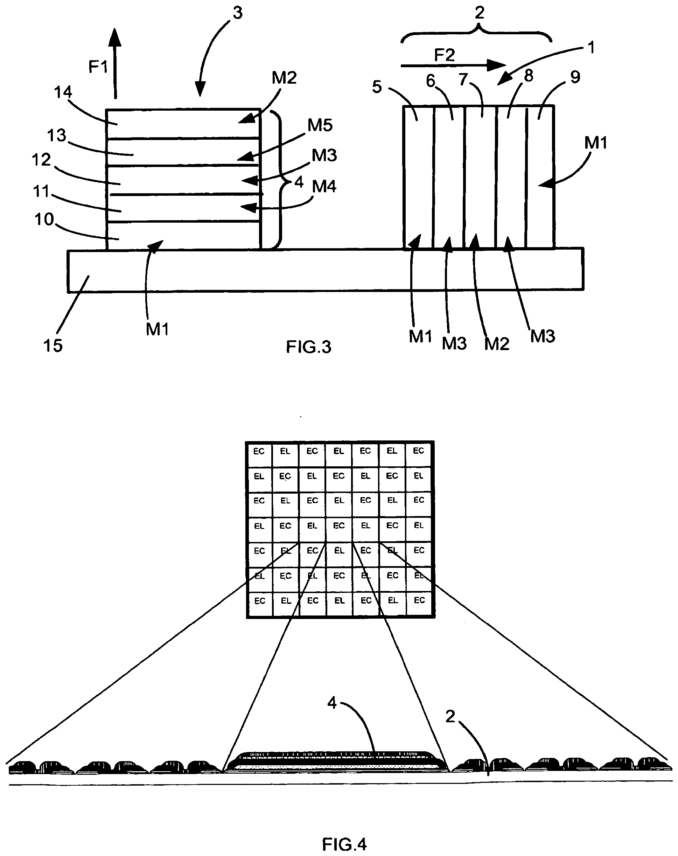

Sur l'exemple des figures 2 et 3, le premier collecteur de courant 5 de l'empilement de l'élément d'affichage électroluminescent 1, le deuxième collecteur de courant 9 de l'empilement de l'élément d'affichage électroluminescent 1, et le premier collecteur de courant 10 de l'élément d'affichage électrochrome 3 sont réalisés avec le matériau M1 et de préférence obtenus à partir d'une même étape de dépôt de M1.

Lors du procédé de fabrication, les couches de matériau M1 des premier et deuxième empilements 2, 4 sont, de préférence déposées, en même temps. Par exemple, il sera utilisé un dépôt d'oxyde transparent conducteur (aussi connu sous l'abréviation « TCO» selon l'acronyme anglais de « Transparent Conductive Oxide »). Ce dépôt peut être de type dépôt physique en phase vapeur (ci-après abrégé « PVD » pour l'acronyme anglais de « Physical Vapor Deposition ») généralement réalisé par pulvérisation réactive radiofréquence (ci-après abrégé RF), le matériau M1 peut être, par exemple, de l'oxyde d'indium dopé à l'étain (ou encore appelé oxyde indium-étain, ci-après abrégé « ITO » selon l'acronyme anglais « Oxyde de Indium Tin ») ou de dioxyde d'étain dopé fluor (aussi connu sous l'abréviation « F:SnO₂ »(Fluorine dopé par de l'Oxyde de Tin). L'épaisseur visée varie entre 100 nm et 500 nm, préférentiellement 250 nm (la valeur de 250 nm est un optimum du compromis donnant la transmittance/conductivité électronique).

Selon une deuxième mise en oeuvre du mode de réalisation préféré (figures 1 à 3), le premier empilement 2 comporte une couche électroluminescente 7 de même matériau M2 qu'une couche formant un collecteur de courant 14 du deuxième empilement 4. Ce collecteur de courant 14 forme par exemple le deuxième collecteur de courant 14 du deuxième empilement 4 opposé au premier collecteur de courant 10 du deuxième l'empilement 4 situé, de préférence, au niveau du substrat de support 15.

Lors du procédé de fabrication, les couches de matériau M2 des deux empilements sont, de préférence, déposées en même temps. Par exemple, par dépôt d'un TCO. Ce dépôt peut être de type PVD et généralement réalisé par pulvérisation réactive RF, le matériau peut être, par exemple, de l'oxyde de zinc (ZnO). L'épaisseur visée varie entre 100 nm et 500 nm, préférentiellement 300 nm.

Selon une troisième mise en oeuvre du mode de réalisation préféré (figures 1 à 3), le deuxième empilement 4 comporte une couche formant un électrolyte 12 de même matériau M3 qu'une couche du premier empilement 1 formant une isolation électrique 6, 8 entre un collecteur de courant 5, 9 du premier empilement 2 et une couche électroluminescente 7 du premier empilement 2.

Sur l'exemple de la figure 1, la couche formant l'électrolyte 12 du deuxième empilement 4 et la couche 6 formant l'isolation électrique au niveau du premier collecteur de courant 5 du premier empilement 2 peuvent être obtenue à partir d'un dépôt simultané du matériau M3.

Sur l'exemple des figures 2 et 3, la couche formant l'électrolyte 12 du deuxième empilement 3 et la couche 6, 8 formant l'isolation électrique au niveau du premier collecteur de courant 5 du premier empilement 1 et au niveau du deuxième collecteur de courant 9 du premier empilement peuvent être obtenue à partir d'un dépôt simultané du matériau M3.

Lors du procédé de fabrication, les couches de matériau M3 des premier et deuxième empilements 2, 4 sont, de préférence, déposées en même temps. Par exemple, par dépôt d'électrolyte conducteur ionique lithium. Ce dépôt peut être réalisé par dépôt PVD, généralement réalisé par pulvérisation ou évaporation thermique. Le matériau M3 peut être par exemple un fluorure de lithium (LiF). L'épaisseur visée de M3 varie entre 50 nm et 200 nm, préférentiellement est égale à 100 nm. La gamme d'épaisseur du matériau M3 sélectionné permet son utilisation à la fois comme conducteur ionique (électrolyte) pour la partie électrochrome et aussi comme isolant électronique (électrique) pour la partie électroluminescente. D'autres matériaux M3 peuvent aussi être utilisés, on peut citer par exemple le LiPON (selon l'acronyme anglais de « lithium phosphorus oxynitride »).

Les première, deuxième et troisième mises en oeuvre peuvent être prises isolément ou en combinaison les unes avec les autres.

Par ailleurs, les première et deuxième électrodes 11, 13 (aussi appelées électrodes d'insertion électrochrome) du deuxième empilement 4 peuvent être réalisées respectivement à partir de dépôts de matériaux M4 et M5.

Concernant le matériau M4, le dépôt de M4 peut être réalisé par dépôt PVD généralement réalisé par pulvérisation réactive RF. Le matériau M4 peut être par exemple un oxyde de tungstène (WO₃). L'épaisseur visée du matériau M4 varie entre 150 nm et 300 nm. D'autres oxydes de métaux de transition peuvent être aussi utilisés en tant que matériau M4, par exemple du pentoxyde de vanadium (V₂O₅).

Concernant le matériau M5, le dépôt de M5 peut être réalisé par dépôt PVD généralement réalisé par pulvérisation réactive RF. Le matériau M5 peut être, par exemple, un oxyde de vanadium lithié LiV₂O₅. L'épaisseur visée varie entre 50 nm et 200 nm, préférentiellement entre 100 nm et 150 nm (transmittance élevée, cinétique de diffusion des ions Li⁺ rapide). D'autres matériaux peuvent être utilisés en tant que matériau M5, par exemple un oxyde de Nickel lithié (LiNiO).

De préférence, lors de la réalisation du procédé de fabrication, les dépôts de matériaux sont réalisés dans l'ordre successif suivant M1, M4, M3, M5, M2.

Avantageusement, chaque couche du premier empilement 2 est aussi présente dans le deuxième empilement 4, même si les fonctions de ces couches peuvent être différentes.

Avantageusement, le premier élément d'affichage 1 comporte une pluralité de premiers empilements 2 disposés côte à côte et formant la zone d'affichage électroluminescente associée.

Comme illustré à la figure 4, le dispositif d'affichage peut comporter une pluralité d'éléments d'affichage électrochrome notés EC et une pluralité d'éléments d'affichage électroluminescent notés EL. Ces éléments sont agencés sous la forme d'une matrice de N lignes et M colonnes. Une ligne et une colonne comportent une alternance d'éléments d'affichage électroluminescent EC et d'éléments d'affichage électrochrome EL. Dans ce cas, chaque élément d'affichage peut constituer un pixel. Comme le montre l'agrandissement, un pixel électrochrome EC peut comporter un unique deuxième empilement 4 alors qu'un pixel électroluminescent EL peut comporter une pluralité de premiers empilements 2. Par exemple, la structure de la figure 4 peut avoir une surface d'affichage de 1 x1 cm², avec des pixels de taille 200x200µm² définissant chacune une zone d'affichage de la surface d'affichage. Les pixels EL peuvent avoir une taille de 200x5µm², et chacun être muni de plusieurs premiers empilements 2 si l'émission des empilements est latérale (zone active répétée plusieurs fois pour augmenter la surface d'émission totale d'un pixel, qui est en fait la somme de toutes les zones d'émission latérales délimitées par chaque premier empilement dudit pixel EL).

La répartition des pixels telle qu'illustrée à la figure 4 n'est qu'un exemple de réalisation non limitatif. De préférence, la répartition des éléments d'affichage électrochrome et des éléments d'affichage électroluminescent est homogène. Cette homogénéité permet d'afficher sélectivement les mêmes données soit exclusivement à partir de la technologie électrochrome soit exclusivement à partir de la technologie électroluminescente sans que la personne lisant ces données ressente une distorsion. Cette homogénéité peut aussi permettre de ne pas générer de distorsion dans les données affichées dans le cas où tous les pixels de la matrice fonctionnent de manière simultanée.

La figure 1 illustre les premier et deuxième empilements réalisés dans une direction F1, c'est-à-dire par superposition des couches en s'éloignant du substrat de support 15 supportant lesdits empilements.

Les figures 2 et 3 illustrent une variante selon laquelle le premier empilement 2 s'étend le long du substrat de support 15 (selon la flèche F2) et le deuxième empilement 4 s'élève du substrat de support 15 dans une direction (flèche F1) opposée audit substrat de support 15. Cette variante est plus simple à fabriquer car elle permet de diminuer le nombre d'étapes de dépôt en les mutualisant le plus possible.

Il résulte de ce qui a été dit ci-dessus qu'un procédé de fabrication d'un dispositif d'affichage peut comprendre de manière générale une étape de formation du premier élément d'affichage 1 et du deuxième élément d'affichage 3.

Avantageusement, cette étape de formation comprend une première étape de dépôt d'un premier matériau réalisée de sorte à former simultanément une couche du premier empilement 2 et une couche du deuxième empilement 4 avec ledit premier matériau.

Ce premier matériau peut être choisi parmi :
- un matériau (par exemple de l'ITO ou du F:SnO₂) formant, après son dépôt, une couche destinée à former au moins un collecteur de courant, de préférence deux collecteurs de courant 5, 9, du premier empilement 2 et une couche destinée à former un des collecteurs de courant 10 du deuxième empilement 4, ou
- un matériau (par exemple ZnO) formant, après son dépôt, une couche électroluminescente du premier empilement et une couche destinée à former un des collecteurs de courant 14 du deuxième empilement 4, ou
- un matériau (par exemple du LiF ou du LiPON) formant, après son dépôt, une couche destinée à former un électrolyte 12 du deuxième empilement 4, et une couche destinée à former une isolation électrique 6, 8 entre au moins un collecteur de courant 5, 9, de préférence deux collecteurs de courant 5, 9, du premier empilement et une couche électroluminescente 7 du premier empilement 2.

L'étape de formation peut comprendre une deuxième étape de dépôt d'un deuxième matériau configurée de sorte à former simultanément une couche du premier empilement 2 et une couche du deuxième empilement 4 avec ledit deuxième matériau.

Le deuxième matériau peut être choisi parmi les mêmes matériaux que le premier matériau à la différence que le deuxième matériau est distinct du premier matériau. Bien entendu, il va de soi que les couches des premier et deuxième empilements formées avec le premier matériau sont distinctes des couches des premier et deuxième empilements formées avec le deuxième matériau.

L'étape de formation peut en outre comprendre une troisième étape de dépôt d'un troisième matériau configurée de sorte à former simultanément une couche du premier empilement 2 et une couche du deuxième empilement 4 avec le troisième matériau.

Le troisième matériau est choisi parmi les mêmes matériaux que le premier matériau à la différence que le troisième matériau est distinct du premier matériau et du deuxième matériau. Bien entendu, il va de soi que les couches des premier et deuxième empilements réalisées respectivement avec les premier et deuxième matériaux sont distinctes des couches des premier et deuxième empilements réalisées avec le troisième matériau.

Comme évoqué précédemment, l'étape de formation des premier et deuxième éléments d'affichage 1, 3 est réalisée de telle manière que chaque couche du premier empilement 2 est associée à une couche du deuxième empilement 4 obtenue par dépôt simultané.

Par ailleurs, l'étape de formation des premier et deuxième éléments d'affichage peut être réalisée à partir du substrat de support 15, le premier empilement 2 s'étend alors le long du substrat de support 15 et le deuxième empilement 4 s'élève du substrat de support 15 dans une direction opposée audit substrat de support 15.

Les applications d'un tel dispositif d'affichage peuvent être des appareils destinés à fonctionner en intérieur et en extérieur, par exemple une carte intelligente (ou smartCard en anglais) munie d'un dispositif d'affichage, un livre numérique, etc. Plus généralement, un appareil destiné à afficher des données dans un environnement à luminosité variable sera préférentiellement équipé du dispositif d'affichage tel que décrit.

Le dispositif d'affichage tel que décrit ci-dessus peut donc se composer d'au moins deux éléments d'affichage, par exemple des pixels de type EC et EL. Le fonctionnement du dispositif est, de préférence, réalisé par l'alimentation des deux types de pixels par une source de courant continu (DC). Le potentiel d'actionnement de la partie électrochrome se situe à ±4V (deux polarités pour l'actionnement de l'état transparent et coloré). Le potentiel d'actionnement de la partie électroluminescente se situe dans la fenêtre 0V à 25V. Les pixels sont actionnés indépendamment les uns par rapport aux autres par l'application de l'alimentation de courant adéquate entre les deux collecteurs de courant relatifs à chacun d'entre eux.

De manière générale, les différentes couches des différents empilements sont, de préférence, transparentes à la longueur d'onde que l'on souhaite afficher.

## Revendications

1. Dispositif d'affichage comprenant un premier élément d'affichage (1) comportant un premier empilement de couches (2) et un deuxième élément d'affichage (3) comportant un deuxième empilement de couches (4), **caractérisé en ce que** les premier et deuxième éléments d'affichage (1, 3) sont disposés côte à côte de sorte à délimiter une première zone d'affichage (Z1) exclusivement électroluminescente associée au premier élément d'affichage (1) et une deuxième zone d'affichage (Z2) exclusivement électrochrome associée au deuxième élément d'affichage (3).

2. Dispositif selon la revendication 1, **caractérisé en ce que** le premier empilement (2) comporte au moins une couche de même matériau qu'une couche du deuxième empilement (4).

3. Dispositif selon la revendication 2, **caractérisé en ce que** le premier empilement (2) comporte une couche formant au moins un collecteur de courant (5, 9), dudit premier empilement (2), de même matériau (M1) qu'une couche du deuxième empilement (4) formant un collecteur de courant (10) du deuxième empilement (4).

4. Dispositif selon l'une des revendications 2 ou 3, **caractérisé en ce que** le premier empilement (2) comporte une couche électroluminescente (7) de même matériau (M2) qu'une couche formant un collecteur de courant (14) du deuxième empilement (4).

5. Dispositif selon l'une des revendications 2 à 4, **caractérisé en ce que** le deuxième empilement (4) comporte une couche formant un électrolyte (12) de même matériau (M3) qu'une couche du premier empilement formant une isolation électrique (6) entre un collecteur de courant (5, 9) du premier empilement (2) et une couche électroluminescente (7) du premier empilement.

6. Dispositif selon l'une des revendications 1 à 5, **caractérisé en ce que** le premier élément d'affichage (1) comporte une pluralité de premiers empilements (2) disposés côte à côte et formant la zone d'affichage électroluminescente associée.

7. Dispositif selon l'une des revendications 1 à 6, **caractérisé en ce que** le premier empilement (2) s'étend le long d'un substrat de support (15) et le deuxième empilement (4) s'élève du substrat de support (15) dans une direction opposée audit substrat de support (15).

8. Dispositif selon l'une quelconque des revendications précédentes **caractérisé en ce qu'**il comprend un module de pilotage (16) de l'affichage configuré de sorte à faire fonctionner sélectivement l'affichage dans les modes suivants :
- Un mode d'affichage exclusivement luminescent,
- Un mode d'affichage exclusivement électrochrome,
- Un mode d'affichage luminescent et électrochrome.

9. Dispositif selon l'une quelconque des revendications précédentes, **caractérisé en ce que** chaque couche du premier empilement (2) est aussi présente dans le deuxième empilement (4).

10. Procédé de fabrication d'un dispositif d'affichage selon la revendication 1, **caractérisé en ce qu'**il comprend une étape de formation du premier élément d'affichage (1) et du deuxième élément d'affichage (3).

11. Procédé selon la revendication 10, **caractérisé en ce que** l'étape de formation comprend une première étape de dépôt d'un premier matériau réalisée de sorte à former simultanément une couche du premier empilement (2) et une couche du deuxième empilement (4) avec le premier matériau.

12. Procédé selon la revendication 11, **caractérisé en ce que** le premier matériau est choisi parmi :
- un matériau (M1) formant, après son dépôt, une couche destinée à former au moins un collecteur de courant (5,9), de préférence deux collecteurs de courant, du premier empilement (2) et une couche destinée à former un des collecteurs de courant (10) du deuxième empilement (4), ou
- un matériau (M2) formant, après son dépôt, une couche électroluminescente (7) du premier empilement (2) et une couche destinée à former un des collecteurs de courant (14) du deuxième empilement (4), ou
- un matériau (M3) formant, après son dépôt, une couche destinée à former un électrolyte (12) du deuxième empilement (4), et une couche destinée à former une isolation électrique (6, 8) entre au moins un collecteur de courant (5, 9), de préférence deux collecteurs de courant (5,9), du premier empilement (2) et une couche électroluminescente (7) du premier empilement (2).

13. Procédé selon la revendication 11, **caractérisé en ce que** l'étape de formation comprend une deuxième étape de dépôt d'un deuxième matériau configurée de sorte à former simultanément une couche du premier empilement (2) et une couche du deuxième empilement (4) avec ledit deuxième matériau.

14. Procédé selon les revendications 12 et 13, **caractérisé en ce que** le deuxième matériau est choisi parmi:
- un matériau (M1) formant, après son dépôt, une couche destinée à former au moins un collecteur de courant, de préférence deux collecteurs de courant, du premier empilement (2) et une couche destinée à former un des collecteurs de courant du deuxième empilement (4), ou
- un matériau (M2) formant, après son dépôt, une couche électroluminescente (7) du premier empilement (2) et une couche destinée à former un des collecteurs de courant (14) du deuxième empilement (4), ou
- un matériau (M3) formant, après son dépôt, une couche destinée à former un électrolyte (12) du deuxième empilement (4), et une couche destinée à former une isolation électrique (6, 8) entre au moins un collecteur de courant (5, 9), de préférence deux collecteurs de courant (5,9), du premier empilement (2) et une couche électroluminescente (7) du premier empilement (2)
ledit deuxième matériau étant distinct du premier matériau.

15. Procédé selon la revendication 13, **caractérisé en ce que** l'étape de formation comprend une troisième étape de dépôt d'un troisième matériau configurée de sorte à former simultanément une couche du premier empilement et une couche du deuxième empilement avec ledit troisième matériau.

16. Procédé selon la revendication 14 et la revendication 15, **caractérisé en ce que** le troisième matériau est choisi parmi:
- un matériau (M1) formant, après son dépôt, une couche destinée à former au moins un collecteur de courant, de préférence deux collecteurs de courant, du premier empilement (2) et une couche destinée à former un des collecteurs de courant du deuxième empilement (4), ou
- un matériau (M2) formant, après son dépôt, une couche électroluminescente (7) du premier empilement (2) et une couche destinée à former un des collecteurs de courant (14) du deuxième empilement (4), ou
- un matériau (M3) formant, après son dépôt, une couche destinée à former un électrolyte (12) du deuxième empilement (4), et une couche destinée à former une isolation électrique (6, 8) entre au moins un collecteur de courant (5, 9), de préférence deux collecteurs de courant (5,9), du premier empilement (2) et une couche électroluminescente (7) du premier empilement (2)
ledit troisième matériau (M3) étant distinct du premier matériau (M1) et du deuxième matériau (M2).

## Patentansprüche

1. Anzeigevorrichtung, umfassend ein erstes Anzeigeelement (1), umfassend einen ersten Schichtenstapel (2), und ein zweites Anzeigeelement (3), umfassend einen zweiten Schichtenstapel (4), **dadurch gekennzeichnet, dass** das erste und das zweite Anzeigeelement (1, 3) nebeneinander angeordnet sind, so dass sie eine ausschließlich elektrolumineszente erste Anzeigezone (Z1), die mit dem ersten Anzeigeelement (1) verknüpft ist, und eine ausschließlich elektrochrome zweite Anzeigezone (Z2), die mit dem zweiten Anzeigeelement (3) verknüpft ist, begrenzen.

2. Anzeigevorrichtung nach Anspruch 1, **dadurch gekennzeichnet, dass** der erste Stapel (2) mindestens eine Schicht aus demselben Material aufweist wie eine Schicht des zweiten Stapels (4).

3. Anzeigevorrichtung nach Anspruch 2, **dadurch gekennzeichnet, dass** der erste Stapel (2) eine Schicht umfasst, die mindestens einen Stromkollektor (5, 9) des ersten Stapels (2) aus demselben Material (M1) umfasst wie eine Schicht des zweiten Stapels (4), die einen Stromkollektor (10) des zweiten Stapels (4) bildet.

4. Anzeigevorrichtung nach einem der Ansprüche 2 oder 3, **dadurch gekennzeichnet, dass** der erste Stapel (2) eine elektrolumineszente Schicht (7) aus demselben Material (M2) umfasst wie eine Schicht, die einen Stromkollektor (14) des zweiten Stapels (4) bildet.

5. Anzeigevorrichtung nach einem der Ansprüche 2 bis 4, **dadurch gekennzeichnet, dass** der zweite Stapel (4) eine Schicht umfasst, die einen Elektrolyten (12) aus demselben Material (M3) bildet wie eine Schicht des ersten Stapels, die eine elektrische Isolierung (6) zwischen einem Stromkollektor (5, 9) des ersten Stapels (2) und einer elektrolumineszenten Schicht (7) des ersten Stapels bildet.

6. Anzeigevorrichtung nach einem der Ansprüche 1 bis 5, **dadurch gekennzeichnet, dass** das erste Anzeigeelement (1) eine Vielzahl von ersten Stapeln (2) umfasst, die nebeneinander angeordnet sind und die damit verknüpfte elektrolumineszente Anzeigezone bilden.

7. Anzeigevorrichtung nach einem der Ansprüche 1 bis 6, **dadurch gekennzeichnet, dass** der erste Stapel (2) sich längs eines Trägersubstrats (15) erstreckt und der zweite Stapel (4) sich vom Trägersubstrat (15) in entgegengesetzter Richtung zum Trägersubstrat (15) erhebt.

8. Vorrichtung nach einem der vorhergehenden Ansprüche, **dadurch gekennzeichnet, dass** sie ein Anzeigesteuerungsmodul (16) umfasst, das so eingerichtet ist, dass es die Anzeige selektiv in folgenden Betriebsarten funktionieren lässt:
- einer ausschließlich lumineszenten Anzeigeart,
- einer ausschließlich elektrochromen Anzeigeart,
- einer lumineszenten und elektrochromen Anzeigeart.

9. Vorrichtung nach einem der vorhergehenden Ansprüche, **dadurch gekennzeichnet, dass** jede Schicht des ersten Stapels (2) auch im zweiten Stapel (4) vorhanden ist.

10. Herstellungsverfahren für eine Anzeigevorrichtung nach Anspruch 1, **dadurch gekennzeichnet, dass** es einen Schritt der Bildung des ersten Anzeigeelements (1) und des zweiten Anzeigeelements (3) umfasst.

11. Verfahren nach Anspruch 10, **dadurch gekennzeichnet, dass** der Schritt der Bildung einen ersten Schritt des Abscheidens eines ersten Materials umfasst, der so durchgeführt wird, dass mit dem ersten Material gleichzeitig eine Schicht des ersten Stapels (2) und eine Schicht des zweiten Stapels (4) gebildet wird.

12. Verfahren nach Anspruch 11, **dadurch gekennzeichnet, dass** das erste Material ausgewählt wird aus:
- einem Material (M1), das nach seinem Abscheiden eine Schicht, die dazu bestimmt ist, mindestens einen Stromkollektor (5, 9), vorzugsweise zwei Stromkollektoren, des ersten Stapels (2) zu bilden, und eine Schicht, die dazu bestimmt ist, einen der Stromkollektoren (10) des zweiten Stapels (4) zu bilden, bildet, oder
- einem Material (M2), das nach seinem Abscheiden eine elektrolumineszente Schicht (7) des ersten Stapels (2) und eine Schicht, die dazu bestimmt ist, einen der Stromkollektoren (14) des zweiten Stapels (4) zu bilden, bildet, oder
- einem Material (M3), das nach seinem Abscheiden eine Schicht, die dazu bestimmt ist, einen Elektrolyten (12) des zweiten Stapels (4) zu bilden, und eine Schicht, die dazu bestimmt ist, eine elektrische Isolierung (6, 8) zwischen mindestens einem Stromkollektor (5, 9), vorzugsweise zwei Stromkollektoren (5, 9), des ersten Stapels (2) und einer elektrolumineszenten Schicht (7) des ersten Stapels (2) zu bilden, bildet.

13. Verfahren nach Anspruch 11, **dadurch gekennzeichnet, dass** der Schritt der Bildung einen zweiten Schritt des Abscheidens eines zweiten Materials umfasst, der so eingerichtet ist, dass er gleichzeitig eine Schicht des ersten Stapels (2) und eine Schicht des zweiten Stapels (4) mit dem zweiten Material bildet.

14. Verfahren nach Anspruch 12 und 13, **dadurch gekennzeichnet, dass** das zweite Material ausgewählt wird aus:
- einem Material (M1), das nach seinem Abscheiden eine Schicht, die dazu bestimmt ist, mindestens einen Stromkollektor, vorzugswiese zwei Stromkollektoren, des ersten Stapels (2) zu bilden, und eine Schicht, die dazu bestimmt ist, einen der Stromkollektoren des zweiten Stapels (4) zu bilden, bildet, oder
- einem Material (M2), das nach seinem Abscheiden eine elektrolumineszente Schicht (7) des ersten Stapels (2) und eine Schicht, die dazu bestimmt ist, einen der Stromkollektoren (14) des zweiten Stapels (4) zu bilden, bildet, oder
- einem Material (M3), das nach seinem Abscheiden eine Schicht, die dazu bestimmt ist, einen Elektrolyten (12) des zweiten Stapels (4) zu bilden, und eine Schicht, die dazu bestimmt ist, eine elektrische Isolierung (6, 8) zwischen mindestens einem Stromkollektor (5, 9), vorzugsweise zwei Stromkollektoren (5, 9), des ersten Stapels (2) und einer elektrolumineszenten Schicht (7) des ersten Stapels (2) zu bilden, bildet,
wobei das zweite Material vom ersten Material verschieden ist.

15. Verfahren nach Anspruch 13, **dadurch gekennzeichnet, dass** der Schritt der Bildung einen dritten Schritt des Abscheidens eines dritten Materials umfasst, der so eingerichtet ist, dass er gleichzeitig eine Schicht des ersten Stapels und eine Schicht des zweiten Stapels mit dem dritten Material bildet.

16. Verfahren nach Anspruch 14 und Anspruch 15, **dadurch gekennzeichnet, dass** das dritte Material ausgewählt wird aus:
- einem Material (M1), das nach seinem Abscheiden eine Schicht, die dazu bestimmt ist, mindestens einen Stromkollektor, vorzugswiese zwei Stromkollektoren, des ersten Stapels (2) zu bilden, und eine Schicht, die dazu bestimmt ist, einen der Stromkollektoren des zweiten Stapels (4) zu bilden, bildet, oder
- einem Material (M2), das nach seinem Abscheiden eine elektrolumineszente Schicht (7) des ersten Stapels (2) und eine Schicht, die dazu bestimmt ist, einen der Stromkollektoren (14) des zweiten Stapels (4) zu bilden, bildet, oder
- einem Material (M3), das nach seinem Abscheiden eine Schicht, die dazu bestimmt ist, einen Elektrolyten (12) des zweiten Stapels (4) zu bilden, und eine Schicht, die dazu bestimmt ist, eine elektrische Isolierung (6, 8) zwischen mindestens einem Stromkollektor (5, 9), vorzugsweise zwei Stromkollektoren (5, 9), des ersten Stapels (2) und einer elektrolumineszenten Schicht (7) des ersten Stapels (2) zu bilden, bildet,
wobei das dritte Material (M3) vom ersten Material (M1) und vom zweiten Material (M2) verschieden ist.

## Claims

1. Display device comprising a first display element (1) comprising a first stack of layers (2) and a second display element (3) comprising a second stack of layers (4), **characterized in that** the first and second display elements (1, 3) are disposed side by side so as to bound a first, exclusively light-emitting, display area (Z1) associated with the first display element (1) and a second, exclusively electrochromic, display area (Z2) associated with the second display element (3).

2. Device according to Claim 1, **characterized in that** the first stack (2) comprises at least one layer of the same material as a layer of the second stack (4).

3. Device according to Claim 2, **characterized in that** the first stack (2) comprises a layer forming at least one current collector (5, 9) of the said first stack (2) of the same material (M1) as a layer of the second stack (4) forming a current collector (10) of the second stack (4).

4. Device according to either of Claims 2 and 3, **characterized in that** the first stack (2) comprises a light-emitting layer (7) of the same material (M2) as a layer forming a current collector (14) of the second stack (4).

5. Device according to one of Claims 2 to 4, **characterized in that** the second stack (4) comprises a layer forming an electrolyte (12) of the same material (M3) as a layer of the first stack forming an electrical insulation (6) between a current collector (5, 9) of the first stack (2) and a light-emitting layer (7) of the first stack.

6. Device according to one of Claims 1 to 5, **characterized in that** the first display element (1) comprises a plurality of first stacks (2) disposed side by side and forming the associated light-emitting display area.

7. Device according to one of Claims 1 to 6, **characterized in that** the first stack (2) runs along a support substrate (15) and the second stack (4) extends upwards from the support substrate (15) in a direction opposite to the said support substrate (15).

8. Device according to any one of the preceding claims, **characterized in that** it comprises a module (16) for driving the display configured so as to selectively make the display operate in the following modes:
- An exclusively light-emitting display mode,
- An exclusively electrochromic display mode,
- A light-emitting and electrochromic display mode.

9. Device according to any one of the preceding claims, **characterized in that** each layer of the first stack (2) is also present in the second stack (4).

10. Method for fabrication of a display device according to Claim 1, **characterized in that** it comprises a step for formation of the first display element (1) and of the second display element (3).

11. Method according to Claim 10, **characterized in that** the formation step comprises a first step for deposition of a first material carried out so as to simultaneously form a layer of the first stack (2) and a layer of the second stack (4) with the first material.

12. Method according to Claim 11, **characterized in that** the first material is chosen from amongst:
- a material (M1) forming, after its deposition, a layer designed to form at least one current collector (5,9), preferably two current collectors, of the first stack (2) and a layer designed to form one of the current collectors (10) of the second stack (4), or
- a material (M2) forming, after its deposition, a light-emitting layer (7) of the first stack (2) and a layer designed to form one of the current collectors (14) of the second stack (4), or
- a material (M3) forming, after its deposition, a layer designed to form an electrolyte (12) of the second stack (4), and a layer designed to form an electrical insulation (6, 8) between at least one current collector (5, 9), preferably two current collectors (5,9), of the first stack (2) and a light-emitting layer (7) of the first stack (2).

13. Method according to Claim 11, **characterized in that** the formation step comprises a second step for deposition of a second material configured so as to simultaneously form a layer of the first stack (2) and a layer of the second stack (4) with the said second material.

14. Method according to Claims 12 and 13, **characterized in that** the second material is chosen from amongst:
- a material (M1) forming, after its deposition, a layer designed to form at least one current collector, preferably two current collectors, of the first stack (2) and a layer designed to form one of the current collectors of the second stack (4), or
- a material (M2) forming, after its deposition, a light-emitting layer (7) of the first stack (2) and a layer designed to form one of the current collectors (14) of the second stack (4), or
- a material (M3) forming, after its deposition, a layer designed to form an electrolyte (12) of the second stack (4), and a layer designed to form an electrical insulation (6, 8) between at least one current collector (5, 9), preferably two current collectors (5,9), of the first stack (2) and a light-emitting layer (7) of the first stack (2)
the said second material being distinct from the first material.

15. Method according to Claim 13, **characterized in that** the formation step comprises a third step for deposition of a third material configured so as to simultaneously form a layer of the first stack and a layer of the second stack with the said third material.

16. Method according to Claim 14 and Claim 15, **characterized in that** the third material is chosen from amongst:
- a material (M1) forming, after its deposition, a layer designed to form at least one current collector, preferably two current collectors, of the first stack (2) and a layer designed to form one of the current collectors of the second stack (4), or
- a material (M2) forming, after its deposition, a light-emitting layer (7) of the first stack (2) and a layer designed to form one of the current collectors (14) of the second stack (4), or
- a material (M3) forming, after its deposition, a layer designed to form an electrolyte (12) of the second stack (4), and a layer designed to form an electrical insulation (6, 8) between at least one current collector (5, 9), preferably two current collectors (5, 9), of the first stack (2) and a light-emitting layer (7) of the first stack (2)
the said third material (M3) being distinct from the first material (M1) and from the second material (M2).
